# EUROPÄISCHE PATENTANMELDUNG

(11) **EP 1 795 852 A1**
(43) Veröffentlichungstag der Anmeldung: **13.06.2007**
(21) Anmeldenummer: 06024355.7
(22) Anmeldetag: 24.11.2006
(51) Int. Cl.: F28F 3/12, H01L 23/473, H05K 7/20

(54) **Kühleinrichtung für Halbleiterbauelemente**

(30) Priorität: 09.12.2005 DE 102005058782
(71) Anmelder: Danfoss Silicon Power GmbH, 24837 Schleswig (DE)
(72) Erfinder: Paulsen, Lars, 25788 Hollingstedt (DE)
(74) Vertreter: Knoblauch, Andreas

(57) **Zusammenfassung**

Es wird eine Kühleinrichtung (1) für Halbleiterbauelemente (2), insbesondere für Hochleistungs-Halbleiterbauelemente, angegeben mit einem Träger (3), der eine erste Seite, an der mindestens ein Halbleiterbauelement (2) angeordnet ist, und eine zweite Seite aufweist, die der ersten Seite gegenüberliegt und mit einem Kühlmittel beaufschlagt ist, das in einem länglichen Kühlmittelraum (12) angeordnet ist, der zumindest teilweise vom Träger (3) begrenzt ist und eine Öffnung (16) aufweist, die durch einen Deckel (17, 18) verschlossen ist.

Man möchte mit geringem baulichen Aufwand gute Kühleigenschaften erreichen.

Hierzu ist vorgesehen, daß die Öffnung (16) eine Umfangslinie aufweist, die kürzer ist als eine Linie, die den größten Querschnitt des Kühlmittelraums (12) umgibt.

## Beschreibung

Die Erfindung betrifft eine Kühleinrichtung für Halbleiterbauelemente, insbesondere für Hochleistungs-Halbleiterbauelemente, mit einem Träger, der eine erste Seite, an der mindestens ein Halbleiterbauelement angeordnet ist, und eine zweite Seite aufweist, die der ersten Seite gegenüberliegt und mit einem Kühlmittel beaufschlagt ist, das in einem länglichen Kühlmittelraum angeordnet ist, der zumindest teilweise vom Träger begrenzt ist und eine Öffnung aufweist, die durch einen Deckel verschlossen ist.

Halbleiterbauelemente erzeugen im Betrieb eine gewisse Wärme. Die dadurch bedingte Temperaturerhöhung ist bis zu einer gewissen Grenze zulässig. Wenn die Temperatur über ein gewisses Maß hinaus ansteigt, kann dies jedoch nachteilige Folgen haben. Zum einen kann die Lebensdauer der Halbleiterbauelemente herabgesetzt werden. Zum anderen kann sich auch der Wirkungsgrad einer Schaltung verringern, in der die Halbleiterbauelemente angeordnet sind.

Es ist daher bekannt, Halbleiterbauelemente mit Kühleinrichtungen zu versehen. Während man für einfache Halbleiterbauelemente vielfach mit Kühlkörpern auskommt, die gut wärmeleitend ausgebildet sind und einfach eine vergrößerte Abstrahlfläche für die Wärme in die Umgebung haben, benötigt man für Hochleistungs-Halbleiterbauelemente vielfach andere Kühlmaßnahmen.

So zeigt DE 202 08 106 U1 eine Kühleinrichtung der eingangs genannten Art. Ein quaderförmiges Gehäuse weist an seiner Oberseite eine Öffnung auf, durch die ein Einsatz eingesetzt werden kann, der zur Verteilung einer Kühlflüssigkeit dient, die durch'Öffnungen zu- und abgeführt wird, die in einer Seitenwand des Gehäuses angeordnet sind. Die Öffnung wird unter Zwischenlage einer Dichtung von einem Deckel verschlossen. Der Dekkel bildet den Träger für die Halbleiterbauelemente.

US 5 841 634 zeigt eine weitere Kühleinrichtung für Halbleiterbauelemente mit einem quaderförmigen Gehäuse, das einen im wesentlichen quadratischen Grundriß aufweist. Die Umfangswände des Gehäuses sind gestuft. Auf einem dadurch gebildeten Absatz liegt ein Verteilerelement auf, das durch eine an der Oberseite des Gehäuses gebildete Öffnung eingesetzt ist. Diese Öffnung wird durch einen Deckel verschlossen, der einen etwas nach innen versetzten bandartigen Flansch aufweist, der eine längere Überdeckung mit der Umfangswand des Gehäuses bildet.

DE 196 43 717 A1 zeigt eine Flüssigkeits-Kühlvorrichtung für ein Hochleistungshalbleitermodul. Die Kühlvorrichtung weist ein quaderförmiges Gehäuse auf, auf dessen Oberseite Halbleitermodule angeordnet sind. Von dieser Oberseite stehen dort, wo die Halbleitermodule angeordnet sind, Zapfengruppen vor. Auch eine Zwischenwand steht von der die Oberseite des Gehäuses bildenden Wand nach innen vor. An der Unterseite ist ein Deckel angeordnet, der das Gehäuse verschließt. Durch den so gebildeten Hohlraum läßt sich ein Kühlmittel leiten. Zum Ein- und Austritt des Kühlmittels sind Anschlußstutzen in einer Seitenwand vorgesehen.

In allen Fällen können die Gehäuse bzw. die die Halbleitermodule tragenden Wände oder Träger aus unterschiedlichen Materialien gebildet sein. Angesprochen werden Kunststoffe, Metalle oder Legierungen. Damit möchte man die Fähigkeit zur Wärmeübertragung von den Halbleitern in das Innere des Gehäuses verbessern.

Die Verwendung einer Flüssigkeit zur Kühlung von Halbleitern hat den Vorteil, daß die Wärmeabfuhr in der Regel besser und wirksamer ist als bei der Verwendung eines gasförmigen Kühlmittels. Allerdings bedingt die Verwendung einer Kühlflüssigkeit einen erhöhten baulichen Aufwand. Man muß dafür Sorge tragen, daß der Kühlmittelraum außen abgedichtet ist. Ein Übertritt einer Kühlflüssigkeit zu den elektrischen Komponenten ist in der Regel unerwünscht, weil er zu gefährlichen Situationen führen und die Halbleiterbauelemente zerstören kann.

Für eine gute Kühlung ist es vielfach erforderlich, das Kühlmittel mit einer nicht zu geringen Strömungsgeschwindigkeit durch die Kühleinrichtung zu leiten. Für den gewünschten Durchfluß ist dann aber ein gewisser Druck erforderlich, der sich negativ auf die Dichtigkeit des Kühlmittelraums auswirken kann.

Der Erfindung liegt die Aufgabe zugrunde, mit geringem baulichen Aufwand gute Kühleigenschaften zu erreichen.

Diese Aufgabe wird bei einer Kühleinrichtung der eingangs genannten Art dadurch gelöst, daß die Öffnung eine Umfangslinie aufweist, die kürzer ist als eine Linie, die den größten Querschnitt des Kühlmittelraums umgibt.

Damit werden zwei Vorteile erreicht. Eine kurze Umfangslinie hat zur Folge, daß die Öffnung des Kühlmittelraums nach außen einen entsprechend geringeren Querschnitt haben kann. Da die Kraft, die auf den die Öffnung verschließenden Deckel wirkt, dem Produkt aus Druck und Fläche des Deckels entspricht, wird bei einer entsprechend geringeren Querschnittsfläche der Öffnung die auf den Deckel wirkende Kraft klein gehalten. Dementsprechend reicht es aus, für die Befestigung des Deckels entsprechend kleinere Kräfte zu verwenden. Darüber hinaus wird die Länge, innerhalb derer Kühlmittel aus dem Kühlmittelraum nach außen treten kann, klein gehalten. Das Risiko, daß sich hier Beschädigungen ergeben, wird entsprechend vermindert. Ein länglicher Kühlmittelraum ist ein Raum, bei dem die Abmessung in einer Dimension größer ist als die Abmessung in mindestens einer anderen Dimension. Wenn man als Dimensionen Breite, Höhe und Länge verwendet, dann ist ein länglicher Kühlmittelraum beispielsweise dann gegeben, wenn die Länge größer ist als die Breite und/oder die Höhe.

Vorzugsweise beträgt die Länge der Umfangslinie maximal 50 % der Länge der den größten Querschnitt umgebenden Linie. Durch diese deutliche Verkürzung der Umfangslinie wird die Problematik der Dichtigkeit erheblich entschärft. Die auf den Deckel wirkenden Kräfte, die versuchen, den Deckel vom Gehäuse abzuheben, werden entsprechend verringert. Bei einer kurzen Dichtlinie, die der Umfangslinie entspricht, lassen sich dementsprechend auch die auf die Dichtung wirkenden Kräfte klein halten. Damit wird die Dichtigkeit verbessert, wenn man den baulichen Aufwand gleich hält, oder man kann die Dichtigkeit auch bei einem verringerten baulichen Aufwand gleich halten.

Vorzugsweise ist der Kühlmittelraum in einem rohrartigen Gehäuse angeordnet, wobei die Öffnung in einer Stirnseite angeordnet ist. Als rohrartiges Gehäuse wird ein Gehäuse angesehen, dessen Länge größer als seine Breite und seine Höhe ist. Ein rohrartiges Gehäuse läßt sich leicht aus einem Rohr herstellen. Wenn man die Öffnung in einer Stirnseite vorsieht, dann läßt sich dort auf einfache Weise die Forderung realisieren, daß die Umfangslinie um die Öffnung kleiner ist als die Linie um den größten Querschnitt des Rohres.

Vorzugsweise weist der Kühlmittelraum zwei Öffnungen auf, die in einander gegenüberliegenden Stirnseiten angeordnet sind. Dies hat den Vorteil, daß man einen Kühlmittelstrom in Längsrichtung durch das Gehäuse erzeugen kann. Der Kühlmittelstrom tritt also durch eine Stirnseite ein und durch die andere Stirnseite aus.

Auch ist von Vorteil, wenn die Öffnung von Längswänden des Gehäuses begrenzt ist. In diesem Fall reicht es aus, das Gehäuse einfach von einem Halbzeug abzulängen, um es auf die richtige Länge zu bringen. Eine weitere Bearbeitung, etwa das Anbringen von Stirnseitenwänden mit Öffnungen, ist nicht erforderlich. Vielmehr kann man das rohrartige Gehäuse dann durch Stirnseitenelemente verschließen, die mit dem rohrartigen Gehäuse abgedichtet verbunden werden.

Hierbei ist besonders bevorzugt, daß das Gehäuse einen rechteckigen Querschnitt aufweist. Damit stehen ebene Flächen am Umfang des Gehäuses zur Verfügung, die für Montagezwecke genutzt werden können. Beispielsweise kann die Oberseite des Gehäuses als Träger genutzt werden, an dem die Halbleiter angeordnet sind. Die Unterseite des Gehäuses kann dann als Befestigungsfläche verwendet werden, mit dem die Kühleinrichtung in einer übergeordneten Anordnung befestigt wird, beispielsweise in einer Antriebsanordnung, für die die an der Kühleinrichtung angeordneten Halbleiterbauelemente die elektrische Energie liefern.

Vorzugsweise ist das Gehäuse als Strangpreßprofil ausgebildet. Strangpreßprofile sind zu verhältnismäßig geringen Kosten im Handel allgemein erhältlich. Es reicht aus, von einem derartigen Profil die gewünschte Länge abzulängen. Alsdann ist das Gehäuse praktisch fertig. Man benötigt nur noch Stirnseitenelemente, die man dicht mit dem Strangpreßprofil verbinden muß, um den Kühlmittelraum abzuschließen.

In einer alternativen Ausgestaltung kann vorgesehen sein, daß das Gehäuse durch ein entlang seiner Längskanten gefaltetes Plattenmaterial gebildet ist. Bei diesem Plattenmaterial kann es sich beispielsweise um ein "Insulated Metal Substrate" (IMS) handeln, das von The Bergquist Company, Chanhassen, Minnesota, USA, oder der Asetronics AG, Bern, Schweiz, angeboten wird. Die IMS-Lösung hat den Vorteil, daß die Hochleistungs-Halbleiterkomponenten direkt auf dem Träger, d.h. einer Gehäusewand, montiert werden können, so daß der Wärmewiderstand des Wärmeleitpfades zwischen den Halbleiterbauelementen und dem Kühlmittel weiter vermindert werden kann.

Auch ist von Vorteil, wenn sich mindestens eine erste Seitenwand des Gehäuses über eine angrenzende zweite Seitenwand des Gehäuses hinaus erstreckt und einen Befestigungsflansch bildet. Seitenwände sind hierbei die in Längsrichtung verlaufenden Wände. Mit Hilfe des Befestigungsflansches ergeben sich Befestigungsmöglichkeiten, bei denen der Kühlmittelraum nicht tangiert wird.

Vorzugsweise ist im Kühlmittelraum ein Verteilereinsatz angeordnet. Der Verteilereinsatz kann für eine gleichmäßige Verteilung des Kühlmittels im Kühlmittelraum sorgen, so daß im Grunde alle Halbleiterbauelemente gleichmäßig temperiert werden können.

Hierbei ist bevorzugt, daß der Verteilereinsatz mit dem Gehäuse eine Vielzahl von Zellen bildet, die in Bezug auf einen Kühlmittelstrom parallel zueinander angeordnet sind. Eine derartige Ausbildung ist prinzipiell aus DE 202 08 106 U1 bekannt. Man kann einen derartigen Verteilereinsatz aber vorliegend so ausbilden, daß man ihn durch die Stirnseite des rohrartigen Gehäuses einführen kann.

Vorzugsweise weist der Deckel mindestens eine Anschlußöffnung für die Zu- oder Abfuhr des Kühlmittels auf. Damit ist eine weitere Bearbeitung des Gehäuses im Grunde nicht erforderlich. Lediglich der Deckel muß mit einer Anschlußöffnung versehen sein. Wenn man dann den Deckel in das Gehäuse einsetzt und den Kühlmittelraum verschließt, dann ist automatisch ein Anschluß für das Kühlmittel gegeben.

Die Erfindung wird im folgenden anhand von bevorzugten Ausführungsbeispielen in Verbindung mit der Zeichnung beschrieben. Hierin zeigen:
- Fig. 1: eine erste Ausgestaltung einer Kühleinrichtung,
- Fig. 2: eine zweite Ausgestaltung einer Kühleinrichtung,
- Fig. 3: die Kühleinrichtung nach Fig. 2 von unten,
- Fig. 4: eine dritte Ausgestaltung einer Kühleinrichtung und
- Fig. 5: eine Abwandlung der Kühleinrichtung nach Fig. 4.

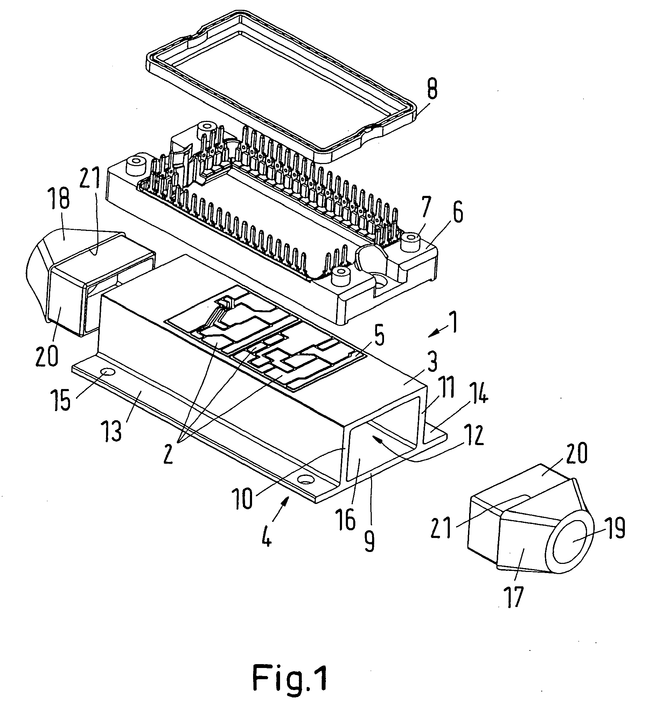

Fig. 1 zeigt eine erste Ausführungsform einer Kühleinrichtung 1 für Hochleistungs-Halbleiterbauelemente 2. Die Halbleiterbauelemente 2 sind an einer Oberseite 3 eines Gehäuses 4 angeordnet. Zwischen den Halbleiterbauelementen 2 und der Oberseite 3 befindet sich ein Substrat 5, das einerseits die Halbleiterbauelemente 2 vom Gehäuse 4 elektrisch isoliert und andererseits einen Wärmeübergang von den Halbleiterbauelementen 2 auf die Oberseite 3 des Gehäuses 4 erlaubt.

Das Gehäuse 4 ist im vorliegenden Ausführungsbeispiel aus einem stranggepreßten oder extrudierten Aluminiumprofil gebildet. Anstelle von Aluminium lassen sich natürlich auch andere Metalle verwenden. Anstelle von Metallen lassen sich auch Kunststoffe verwenden, wenn ihre Wärmeleitfähigkeit ausreichend hoch ist. Auch ein Metallhydrid, beispielsweise AlSiC, kann verwendet werden.

Das Gehäuse 4 kann, wie dargestellt, aus einem stranggepreßten Profil gebildet sein. Es kann auch dadurch hergestellt werden, daß ein platten- oder blechförmiges Material gefaltet und dann gewickelt wird. Für eine derartige Ausbildung läßt sich insbesondere ein "Insulated Metal Substrate" (IMS) verwenden, das beispielsweise von The Bergquist Company, Chanhassen, Minnesota, USA, oder von der Asetronics AG, Bern, Schweiz, angeboten wird. Die IMS-Lösung hat den Vorteil, daß die Leistungs-Halbleiterbauelemente 2 direkt auf dem Material des Gehäuses montiert werden können, was den thermischen Widerstand im Wärmeleitpfad reduziert. Ein Substrat 5 ist hier nicht erforderlich.

Andererseits hat die Verwendung eines Substrats 5 den Vorteil, daß die Halbleiterbauelemente 2 zuvor auf dem Substrat 5 montiert werden können, das seinerseits wiederum durch Löten, Kleben oder Schweißen auf der Oberseite 3 des Gehäuses 4 befestigt werden kann. Sobald die Halbleiterbauelemente montiert worden sind, wird ein Modulrahmen 6 mit elektrischen Anschlüssen 7 montiert und mit den Halbleiterbauelementen 2 verbunden. Die ganze Anordnung kann dann durch eine Abdeckung 8 abgedeckt werden.

Das Gehäuse 4 weist neben der Oberseite 3 eine Unterseite 9 und zwei Seitenwände 10, 11 auf. Die Oberseite 3 und die Unterseite 9 können dementsprechend auch als obere Wand und als untere Wand bezeichnet werden. Die vier Wände 3, 9-11 umgeben einen Kühlmittelraum 12, der einen rechteckförmigen Querschnitt hat. Der Kühlmittelraum 12 ist, wie dies aus Fig. 1 zu erkennen ist, länglich ausgebildet, d.h. der Kühlmittelraum 12 ist in eine Richtung, die sich parallel zu den vier Wänden 3, 9-11 erstreckt, wesentlich größer als in die Richtungen senkrecht dazu.

Die untere Wand 9 erstreckt sich über die Seitenwände 10, 11 auf beiden Seiten hinaus und bildet dadurch Befestigungsflansche 13, 14 mit Befestigungsbohrungen 15, so daß das Gehäuse 4 an einer Unterlage (nicht näher dargestellt) befestigt werden kann.

Das Gehäuse 4 ist an seinen beiden Stirnseiten offen. Der Kühlmittelraum 12 weist also an seinen beiden Stirnseiten eine Öffnung 16 auf, die von der Oberseite 3, der Unterseite 9 und den beiden Seitenwänden 10, 11 umgrenzt ist. Die Stirnseiten dieser Wände 3, 9-11 bilden eine Umfangslinie, die wesentlich kürzer ist als eine Linie, die den größten Querschnitt des Kühlmittelraums 12 umgibt. Dieser Querschnitt wird im vorliegenden Ausführungsbeispiel in einer Ebene liegen, die parallel zu den Befestigungsflanschen 13, 14 liegt.

Die Öffnungen 16 sind jeweils durch Deckel 17, 18 verschlossen. Die beiden Deckel 17, 18 sind aus Gründen der Darstellung in Fig. 1 in einer abgezogenen Position gezeigt. Jeder Deckel 17, 18 weist einen Anschluß 19 zur Zu- bzw. Abfuhr von Kühlmittel in flüssiger Form auf.

Jeder Deckel 17, 18 weist auf der dem Anschluß abgewandten Seite einen vorstehenden Flansch 20 auf, der in den Kühlmittelraum 12 eingeführt wird und dann von innen an der oberen Wand 3, an der unteren Wand 9 und an den beiden Seitenwänden 10, 11 anliegt. Der Deckel 17, 18 liegt im montierten Zustand dann mit einer Dichtfläche 21 an der Stirnseite des Gehäuses 4 an, wobei die Länge dieser Dichtfläche 21 genau so groß ist wie die Länge der Umfangslinie, die die Öffnung 16 umgibt. Da man die Umfangslinie, wie oben erwähnt, relativ kurz hält, entsteht auch nur eine relativ kurze Dichtfläche 21.

In nicht näher dargestellter Weise können zwischen der Dichtfläche 21 und dem Gehäuse 4 auch noch Dichtungen oder ähnliche Einrichtungen angeordnet sein, um einen Austritt der Kühlmittelflüssigkeit aus dem Kühlmittelraum 12 zu verhindern. Dadurch ist es möglich, daß man ein flüssiges Kühlmittel auch mit einem etwas erhöhten Druck durch den Kühlmittelraum 12 leiten kann, ohne daß es im Bereich der Deckel 17, 18 in unerwünschter Weise austritt.

In vielen Fällen wird es ausreichen, die Deckel 17, 18 im Bereich des Flansches 20 mit dem Gehäuse 4 zu verkleben, zu verlöten oder zu verschweißen. Wenn dies nicht ausreicht, können andere mechanische Befestigungsmittel vorgesehen sein, beispielsweise Schrauben oder ähnliches, die in der Zeichnung aber aus Gründen der Übersicht nicht dargestellt sind.

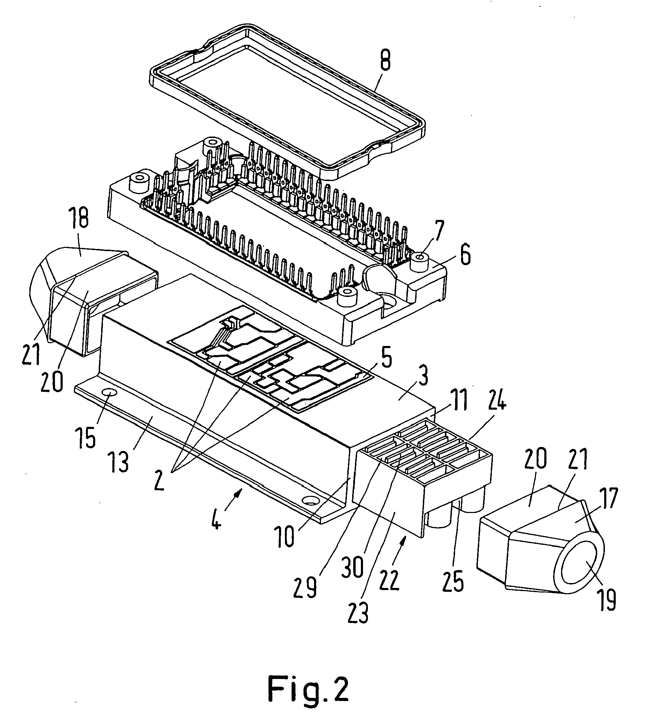

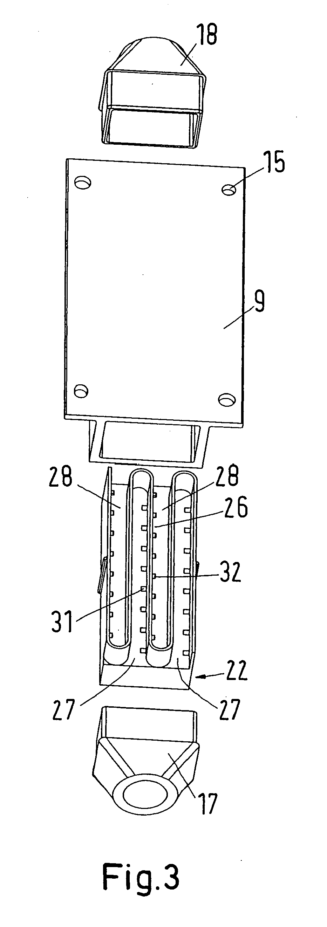

Die Fig. 2 und 3 zeigen eine abgewandelte Ausführungsform. Gleiche Elemente sind mit den gleichen Bezugszeichen wie in Fig. 1 versehen.

Hinzugekommen ist ein Verteilereinsatz 22, der von einer Stirnseite her in das Gehäuse 4 eingeschoben ist. Der Verteilereinsatz 22 weist zwei Seitenwände 23, 24 auf, die von innen an den Seitenwänden 10, 11 des Gehäuses 4 anliegen. Die Höhe des Verteilereinsatzes 22 entspricht dem Abstand zwischen der Oberseite 3 und der Unterseite 9 des Gehäuses. Dementsprechend liegt der Verteilereinsatz 22 von innen dicht am Gehäuse 4 an. Kleinere Undichtigkeiten können dabei in Kauf genommen werden.

Der Verteilereinsatz 22 kann im Grunde jede Form haben, die eine Steuerung des Kühlmittelstromes erlaubt, wobei die Steuerung des Kühlmittelstromes so erfolgen soll, daß die Halbleiterbauelemente 2 gleichmäßig gekühlt werden.

Im vorliegenden Ausführungsbeispiel weist der Verteilereinsatz 22 zunächst eine Trennwand 25 auf, die den Kühlmittelraum 12 zwischen der Oberseite 3 und der Unterseite 9 in zwei Abschnitte unterteilt. Im unteren Abschnitt, d.h. dem Abschnitt, der der Unterseite 9 benachbart ist, ist eine mäanderförmig geführte Wand 26 vorgesehen, die einen Zuflußbereich 27 von einem Abflußbereich 28 trennt.

Im oberen Bereich sind mehrere Zellen 29 vorgesehen, wobei in jeder Zelle 29 noch Leitwände 30 zur Steuerung eines Kühlmittelstromes vorgesehen sein können. Für jede Zelle ist auf der Unterseite der Trennwand 25 ein Einlaß 31 vorgesehen, der mit dem Zuflußbereich 27 in Verbindung steht, und ein Auslaß 32, der mit dem Abflußbereich 28 in Verbindung steht. Dadurch wird erreicht, daß alle Zellen 29 in Bezug auf den Strom des flüssigen Kühlmittels parallel geschaltet sind. Das flüssige Kühlmittel tritt also durch einen Deckel 17 in den Kühlmittelraum 12 ein und durch den anderen Deckel 18 aus.

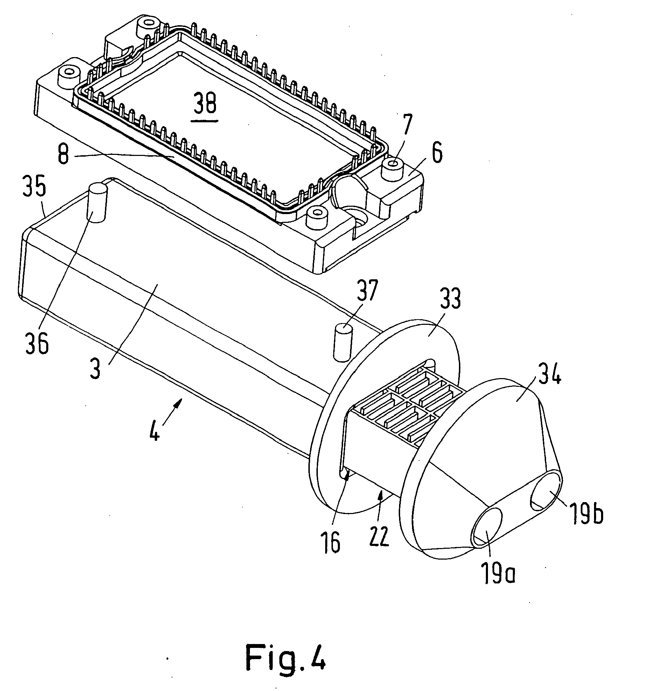

Fig. 4 zeigt eine abgewandelte Ausführungsform, bei der gleiche Elemente mit den gleichen Bezugszeichen wie in den Fig. 1 bis 3 versehen sind.

Beim Gehäuse 4 hat man auf die Befestigungsflansche 13, 14 verzichtet. Dafür ist an einer Stirnseite ein kreisförmiger Flansch 33 vorgesehen, der die Öffnung 16 umgibt.

Es ist auch nur ein Deckel 34 vorgesehen, der dafür zwei Anschlüsse 19a, 19b aufweist, so daß durch einen Deckel 34 sowohl der Zufluß als auch der Abfluß von flüssigem Kühlmittel erfolgen kann. Die gegenüberliegende Stirnseite 35 des Gehäuses 4 ist fest verschlossen, beispielsweise dadurch, daß hier eine Platte festgeschweißt, festgelötet oder festgeklebt ist. Die Platte kann aus einem anderen Material als das Gehäuse 4 gebildet sein, beispielsweise aus Kunststoff.

Der Verteilereinsatz 22 entspricht prinzipiell dem aus den Fig. 2 und 3. Man muß lediglich dafür sorgen, daß der Abflußbereich 28 (in Fig. 4 nicht dargestellt) zum Anschluß 19b zurückgeführt wird.

Das Gehäuse 4 weist an seiner Oberseite 3 Montagebolzen 36, 37 auf, auf denen das Leistungshalbleiter-Modul 38 befestigt werden kann, beispielsweise dadurch, daß es dort festgeschraubt wird. Auch dadurch läßt sich ein guter Wärmeübergang zwischen den in Fig. 4 nicht näher dargestellten Halbleiterbauelementen des Halbleiterbauelementmoduls 38 und dem Gehäuse 4 sicherstellen.

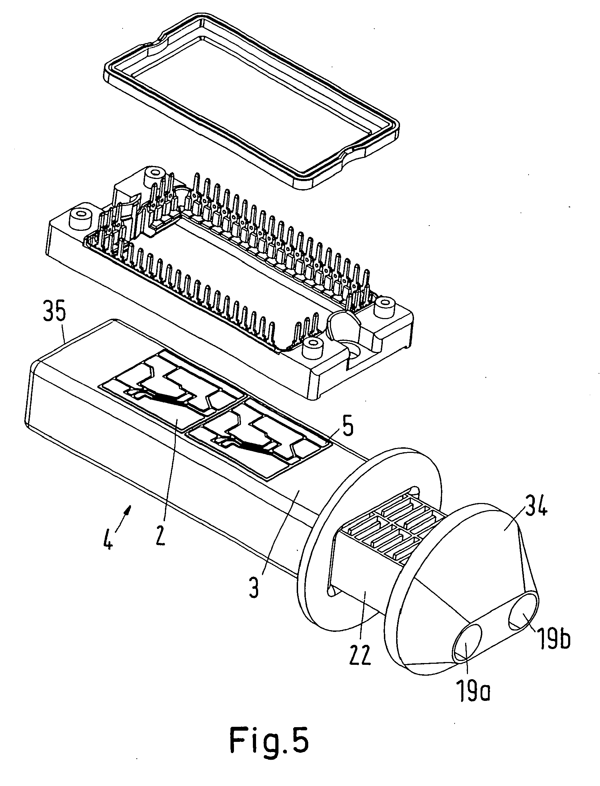

Fig. 5 zeigt eine abgewandelte Ausgestaltung, bei der die Ideen aus den Fig. 2 und 3 einerseits und der Fig. 4 andererseits kombiniert sind.

Die Kühleinrichtung nach Fig. 5 weist wiederum einen Verteilereinsatz 22 auf, der mit einem einzelnen Deckel 34 zusammenwirkt. Auf der gegenüberliegenden Stirnseite 35 kann, wie im Zusammenhang mit Fig. 4 erläutert, eine Platte vorgesehen sein, die den Kühlmittelraum 12 abschließt. Diese Platte kann auch aus einem anderen Material als das Gehäuse 4 gebildet sein.

Die Halbleiterbauelemente 2 sind wiederum über ein Substrat 5 mit der Oberseite 3 des Gehäuses 4 verbunden.

Die Deckel 17, 18, 34 können aus einem Material gebildet sein, das vom Material des Gehäuses 4 abweicht. Beispielsweise kann das Gehäuse 4 aus Metall gebildet sein, während die Deckel 17, 18, 34 aus Kunststoff gebildet sind. Die Verwendung von Kunststoff für die Dekkel 17, 18, 34 erleichtert deren Fertigung.

## Patentansprüche

1. Kühleinrichtung für Halbleiterbauelemente, insbesondere für Hochleistungs-Halbleiterbauelemente, mit einem Träger, der eine erste Seite, an der mindestens ein Halbleiterbauelement angeordnet ist, und eine zweite Seite aufweist, die der ersten Seite gegenüberliegt und mit einem Kühlmittel beaufschlagt ist, das in einem länglichen Kühlmittelraum angeordnet ist, der zumindest teilweise vom Träger begrenzt ist und eine Öffnung aufweist, die durch einen Deckel verschlossen ist, **dadurch gekennzeichnet, daß** die Öffnung (16) eine Umfangslinie aufweist, die kürzer ist als eine Linie, die den größten Querschnitt des Kühlmittelraums (12) umgibt.

2. Kühleinrichtung nach Anspruch 1, **dadurch gekennzeichnet, daß** die Länge der Umfangslinie maximal 50 % der Länge der den größten Querschnitt umgebenden Linie beträgt.

3. Kühleinrichtung nach Anspruch 1 oder 2, **dadurch gekennzeichnet, daß** der Kühlmittelraum (12) in einem rohrartigen Gehäuse (4) angeordnet ist, wobei die Öffnung (16) in einer Stirnseite angeordnet ist.

4. Kühleinrichtung nach Anspruch 3, **dadurch gekennzeichnet, daß** der Kühlmittelraum (12) zwei Öffnungen (16) aufweist, die in einander gegenüberliegenden Stirnseiten angeordnet sind.

5. Kühleinrichtung nach Anspruch 3 oder 4, **dadurch gekennzeichnet, daß** die Öffnung (16) von Längswänden (3, 9, 10, 11) des Gehäuses (4) begrenzt ist.

6. Kühleinrichtung nach einem der Ansprüche 3 bis 5, **dadurch gekennzeichnet, daß** das Gehäuse (4) einen rechteckigen Querschnitt aufweist.

7. Kühleinrichtung nach einem der Ansprüche 3 bis 6, **dadurch gekennzeichnet, daß** das Gehäuse (4) als Strangpreßprofil ausgebildet ist.

8. Kühleinrichtung nach einem der Ansprüche 3 bis 6, **dadurch gekennzeichnet, daß** das Gehäuse (4) durch ein entlang seiner Längskanten gefaltetes Plattenmaterial gebildet ist.

9. Kühleinrichtung nach einem der Ansprüche 6 bis 8, **dadurch gekennzeichnet, daß** sich mindestens eine erste Seitenwand (9) des Gehäuses (4) über eine angrenzende zweite Seitenwand (10, 11) des Gehäuses (4) hinaus erstreckt und einen Befestigungsflansch (13, 14) bildet.

10. Kühleinrichtung nach einem der Ansprüche 1 bis 9, **dadurch gekennzeichnet, daß** im Kühlmittelraum (12) ein Verteilereinsatz (22) angeordnet ist.

11. Kühleinrichtung nach Anspruch 10, **dadurch gekennzeichnet, daß** der Verteilereinsatz (22) mit dem Gehäuse (4) eine Vielzahl von Zellen (29) bildet, die in Bezug auf einen Kühlmittelstrom parallel zueinander angeordnet sind.

12. Kühleinrichtung nach einem der Ansprüche 1 bis 11, **dadurch gekennzeichnet, daß** der Deckel (17, 18, 34) mindestens eine Anschlußöffnung (19, 19a, 19b) für die Zu- oder Abfuhr des Kühlmittels aufweist.
